# EUROPEAN PATENT APPLICATION

(11) **EP 4 565 026 A2**
(43) Date of publication of application: **04.06.2025**
(21) Application number: 24183063.7
(22) Date of filing: 19.06.2024
(51) Int. Cl.: H10D 30/01, H10D 30/40, H10D 64/01, H10D 62/13, H10D 64/23, H10D 64/27, H10D 30/00, H10D 62/10, H10D 30/67, B82Y 10/00

(54) **METHOD OF MAKING A STACKED NANOSHEET MOSFET, COMPRISING A STEP OF OXIDIZING A SILICON LAYER AND THE NANOSHEETS TO FORM THE GATE DIELECTRIC.**

(30) Priority: 28.11.2023 KR 20230168112
(71) Applicant: Samsung Electronics Co., Ltd., Suwon-si, Gyeonggi-do 16677 (KR)
(72) Inventor: MYUNG, Taehun, 16677 Suwon-si, Gyeonggi-do (KR); JEONG, Jaehun, 16677 Suwon-si, Gyeonggi-do (KR); KIM, Seokhoon, 16677 Suwon-si, Gyeonggi-do (KR); MASUOKA, Yuri, 16677 Suwon-si, Gyeonggi-do (KR); HONG, Soohun, 16677 Suwon-si, Gyeonggi-do (KR); KIM, Minyi, 16677 Suwon-si, Gyeonggi-do (KR); SHIN, Wooseung, 16677 Suwon-si, Gyeonggi-do (KR); LEE, Sanghyeon, 16677 Suwon-si, Gyeonggi-do (KR); JEONG, Dongchan, 16677 Suwon-si, Gyeonggi-do (KR)
(74) Representative: Kuhnen & Wacker Patent- und Rechtsanwaltsbüro PartG mbB

(57) **Abstract**

A method of manufacturing a semiconductor device, includes forming a stacked pattern including an active layer (SP1-3) and a sacrificial layer stacked on a substrate, wherein the active layer includes at least two active layers vertically adjacent to each other, and the sacrificial layer is interposed between the two active layers; forming a source/drain recess by etching the stacked pattern; forming an indent (IDE) by etching a portion of the sacrificial layer exposed by the source/drain recess; forming a silicon layer (GL) on an inner surface of the source/drain recess; forming an inner spacer (ISP) in the indent (IDE); forming an inner region (IRG) by removing the sacrificial layer; and forming a gate insulating layer (GI) and a gate electrode (GE) in the inner region, wherein the forming the gate insulating layer (GI) includes forming an oxide layer by performing an oxidation process on the silicon layer (GL) exposed by the inner region.

## Description

### CROSS-REFERENCE TO RELATED APPLICATION

This application is based on and claims priority under 35 U.S.C. § 119 to Korean Patent Application No. No.10-2023-0168112, filed on November 28, 2023, in the Korean Intellectual Property Office, the disclosure of which is incorporated by reference herein in its entirety.

### BACKGROUND

### 1. Field

The disclosure relates to a semiconductor device and a method of manufacturing the same, and more particularly, relates to a semiconductor device including a field effect transistor and a method of manufacturing the same semiconductor device.

### 2. Description of Related Art

A semiconductor device may include an integrated circuit including metal-oxide-semiconductor field effect transistors (MOSFETs). As sizes and design rules of semiconductor devices have been reduced, sizes of MOSFETs have also been reduced. Operating characteristics of semiconductor devices may be deteriorated by the reduced sizes of the MOSFETs. Thus, various researches are being conducted for semiconductor devices capable of overcoming limitations caused by a high integration density and of improving performance.

### SUMMARY

Provided is a semiconductor device with improved reliability and electrical characteristics. Provided is a method of manufacturing a semiconductor device with improved reliability and electrical characteristics.

According to an aspect of the disclosure, a method of manufacturing a semiconductor device, includes: forming a stacked pattern including an active layer and a sacrificial layer stacked on a substrate, wherein the active layer includes two active layers vertically adjacent to each other, and the sacrificial layer is interposed between the two active layers; forming a recess by etching the stacked pattern; forming an indent by etching a portion of the sacrificial layer exposed by the recess; forming a silicon layer on an inner surface of the recess; forming an inner spacer in the indent; forming an inner region by removing the sacrificial layer; and forming a gate insulating layer in the inner region, wherein the forming the gate insulating layer includes forming an oxide layer by performing an oxidation process on the silicon layer exposed by the inner region.

According to an aspect of the disclosure, a method of manufacturing a semiconductor device, includes: forming a stacked pattern including a semiconductor pattern and a sacrificial layer stacked on a substrate; forming a recess by etching the stacked pattern; forming an indent by etching a portion of the sacrificial layer exposed by the recess; forming a silicon layer on an inner surface of the recess, the silicon layer including a first portion on the semiconductor pattern and a second portion on the sacrificial layer; forming an inner spacer in the indent; and forming a source/drain pattern in the recess, wherein the semiconductor pattern includes a body portion and a protrusion protruding from the body portion toward the source/drain pattern, and wherein a highest level of the body portion and a highest level of the first portion covering the protrusion are equal to each other.

According to an aspect of the disclosure, a semiconductor device includes: a substrate including an active pattern; a first semiconductor pattern and a second semiconductor pattern stacked on the active pattern and vertically spaced apart from each other; a source/drain pattern connected to the first semiconductor pattern and the second semiconductor pattern; a silicon layer between the first semiconductor pattern and the source/drain pattern; a gate electrode between the first semiconductor pattern and the second semiconductor pattern; a gate insulating layer between the gate electrode and the source/drain pattern; a high dielectric layer surrounding the gate electrode; and an inner spacer between the gate insulating layer and the source/drain pattern, wherein the first semiconductor pattern includes a body portion and a protrusion protruding from the body portion toward the source/drain pattern, and wherein a first highest level of the body portion is equal to a second highest level of the silicon layer covering the protrusion.

### BRIEF DESCRIPTION OF THE DRAWINGS

The above and other aspects, features, and advantages of certain embodiments of the disclosure will be more apparent from the following description taken in conjunction with the accompanying drawings, in which:
FIGS. 1 to 3 are diagrams for illustrating logic cells of a semiconductor device according to some embodiments of the disclosure;
FIG. 4 is a plan view for illustrating a semiconductor device according to some embodiments of the disclosure;
FIGS. 5A to 5D are cross-sectional views taken along lines A-A', B-B', C-C', and D-D' of FIG. 4, respectively;
FIG. 6 is an enlarged view illustrating an example of region 'M' of FIG. 5A;
FIGS. 7A to 12D are cross-sectional views for illustrating a method of manufacturing a semiconductor device according to embodiments of the disclosure; and
FIGS. 13 to 17 are diagrams illustrating a method of manufacturing the semiconductor device according to FIG. 6 and are enlarged views for illustrating the method of forming region 'M' of FIG. 5A.

### DETAILED DESCRIPTION

Hereinafter, to explain the disclosure in detail, embodiments according to the disclosure will be described with reference to the accompanying drawings.

The terms "include" and "comprise", and the derivatives thereof refer to inclusion without limitation. The term "or" is an inclusive term meaning "and/or." The phrase "at least one of," when used with a list of items, means that different combinations of one or more of the listed items may be used, and only one item in the list may be needed. For example, "at least one of A, B, and C" includes any of the following combinations: A, B, C, A and B, A and C, B and C, and A and B and C, and any variations thereof. As an additional example, the expression "at least one of a, b, or c" may indicate only a, only b, only c, both a and b, both a and c, both b and c, all of a, b, and c, or variations thereof. Similarly, the term "set" means one or more. Accordingly, the set of items may be a single item or a collection of two or more items.

The description merely illustrates the principles of the disclosure. Those skilled in the art will be able to devise one or more arrangements that, although not explicitly described herein, embody the principles of the disclosure. Furthermore, all examples recited herein are principally intended expressly to be only for explanatory purposes to help the reader in understanding the principles of the disclosure and the concepts contributed by the inventor to furthering the art and are to be construed as being without limitation to such specifically recited examples and conditions. Moreover, all statements herein reciting principles, aspects, and embodiments of the disclosure, as well as specific examples thereof, are intended to encompass equivalents thereof.

Terms used in the disclosure are used only to describe a specific embodiment, and may not be intended to limit the scope of another embodiment. A singular expression may include a plural expression unless it is clearly meant differently in the context. The terms used herein, including a technical or scientific term, may have the same meaning as generally understood by a person having ordinary knowledge in the technical field described in the present disclosure. Terms defined in a general dictionary among the terms used in the present disclosure may be interpreted with the same or similar meaning as a contextual meaning of related technology, and unless clearly defined in the present disclosure, it is not interpreted in an ideal or excessively formal meaning. In some cases, even terms defined in the disclosure cannot be interpreted to exclude embodiments of the present disclosure.

In one or more embodiments of the disclosure described below, a hardware approach is described as an example. However, since the one or more embodiments of the disclosure include technology that uses both hardware and software, the various embodiments of the present disclosure do not exclude a software-based approach.

In addition, in the disclosure, in order to determine whether a specific condition is satisfied or fulfilled, an expression of more than or less than may be used, but this is only a description for expressing an example, and does not exclude description of more than or equal to or less than or equal to. A condition described as `more than or equal to' may be replaced with `more than', a condition described as `less than or equal to' may be replaced with `less than', and a condition described as `more than or equal to and less than' may be replaced with `more than and less than or equal to.'

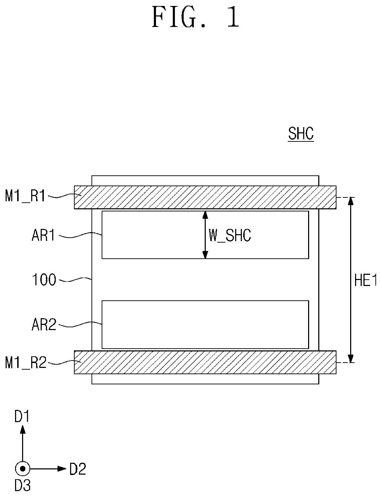

FIGS. 1 to 3 are diagrams for illustrating logic cells of a semiconductor device according to some embodiments of the disclosure.

FIG. 1 illustrates a single height cell SHC. In an embodiment, a first power wiring M1_R1 and a second power wiring M1_R2 may be provided on a substrate 100. The first power wiring M1_R1 may be a path through which a source voltage VSS, for example, a ground voltage is provided. The second power wiring M1_R2 may be a passage through which a drain voltage VDD, for example, a power voltage is provided.

A single height cell SHC may be defined between the first power wiring M1_R1 and a second power wiring M1_R2. The single height cell SHC may include one first active region AR1 and one second active region AR2. One of the first active region AR1 and the second active region AR2 may be a p-type metal-oxide-semiconductor field-effect transistor (PMOSFET) region, and the other of the first active region AR1 and the second active region AR2 may be a n-type MOSFET (NMOSFET) region. That is, the single height cell SHC may have a complementary metal-oxide-semiconductor (CMOS) structure provided between the first power wiring M1_R1 and the second power wiring M1_R2. For example, the first active region AR1 may be an NMOSFET region, and the second active region AR2 may be a PMOSFET region.

Each of the first active region AR1 and the second active region AR2 may have a first width W_SCH in a first direction D1. A length of the single height cell SHC in the first direction D1 may be defined as a first height HE1. The first height HE1 may be substantially equal to a distance (e.g., a pitch) between the first power wiring M1_R1 and the second power wiring M1_R2.

The single height cell SHC may constitute one logic cell. In this specification, a logic cell may mean a logic element (e.g., AND, OR, XOR, XNOR, inverter, etc.) that performs a specific function. That is, the logic cell may include transistors constituting a logic device and wirings connecting the transistors to one another.

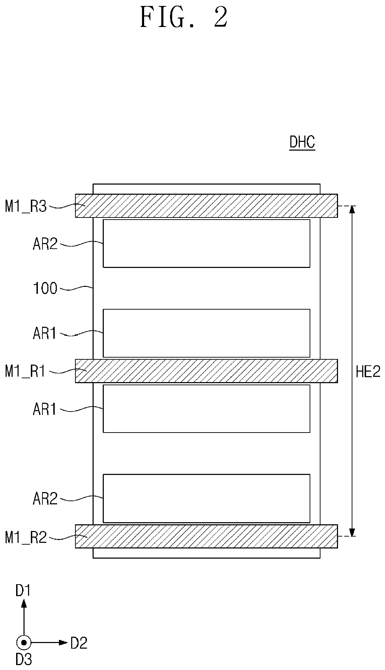

Referring to FIG. 2, a double height cell DHC may be provided. In an embodiment, a first power wiring M1_R1, a second power wiring M1_R2, and a third power wiring M1_R3 may be provided on a substrate 100. The first power wiring M1_R1 may be disposed between the second power wiring M1_R2 and the third power wiring M1_R3. The third power wiring M1_R3 may be a path through which a source voltage VSS is provided.

The double height cell DHC may be defined between the second power wiring M1_R2 and the third power wiring M1_R3. In an embodiment, as shown in FIG. 2, the double height cell DHC may include two first active regions AR1 (above M1_R1), AR1 (below M1_R1) and two second active regions AR2 (above M1_R2), AR2 (below M1_R3).

One of the two second active regions AR2 may be adj acent to the second power wiring M1_R2. The other of the two second active regions AR2 may be adjacent to the third power wiring M1_R3. The two first active regions AR1 may be adjacent to the first power wiring M1_R1. When viewed in a plan view, the first power wiring M1_R1 may be disposed between the two first active regions AR1.

A length of the double height cell DHC in a first direction D1 may be defined as a second height HE2. The second height HE2 may be about twice of the first height HE1 in FIG. 1. The two first active regions AR1 of the double height cell DHC may be grouped to operate as one active region.

In the disclosure, the double height cell DHC shown in FIG. 2 may be defined as a multi-height cell. In an embodiment, the multi-height cell may include a triple-height cell having a cell height approximately three times the height of the single height cell SHC.

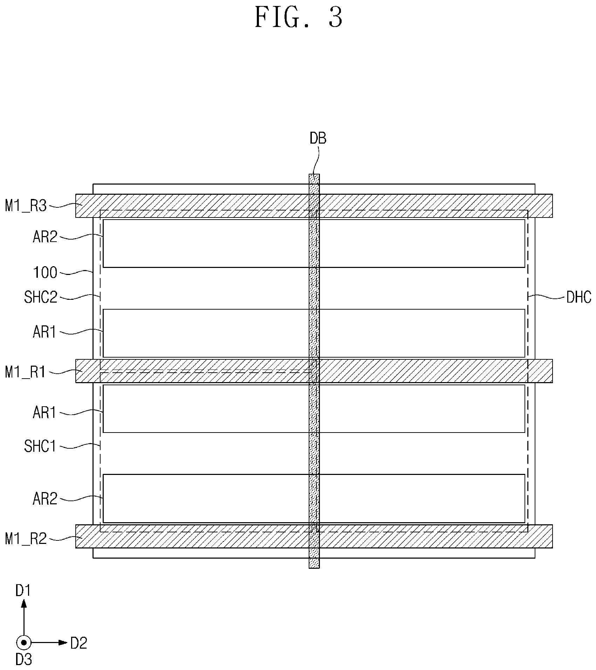

Referring to FIG. 3, a first single height cell SHC1, a second single height cell SHC2, and a double height cell DHC may be two-dimensionally disposed on a substrate 100. The first single height cell SHC1 may be disposed between the first power wiring M1_R1 and the second power wiring M1_R2. The second single height cell SHC2 may be disposed between the first power wiring M1_R1 and the third power wiring M1_R3. The second single height cell SHC2 may be adjacent to the first single height cell SHC1 in a first direction D1.

The double height cell DHC may be disposed between the second power wiring M1_R2 and the third power wiring M1_R3. The double height cell DHC may be adjacent to the first single height cell SHC1 and the second single height cell SHC2 in a second direction D2.

A separation structure DB may be provided between the first single height cell SHC1 and the double height cell DHC, and between the second single height cell SHC2 and the double height cell DHC. By the separation structure DB, the active region of the double height cell DHC may be electrically separated from the active regions of each of the first single height cell SHC1 and the second single height cell SHC2.

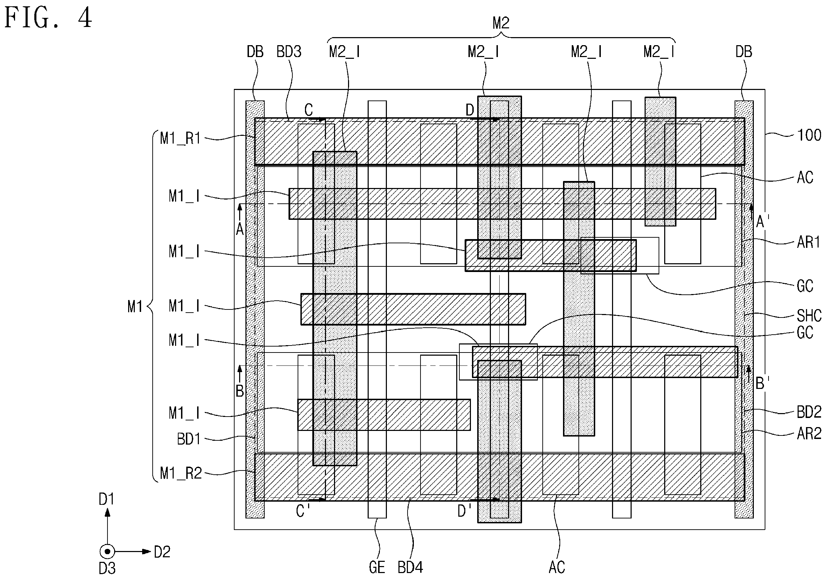

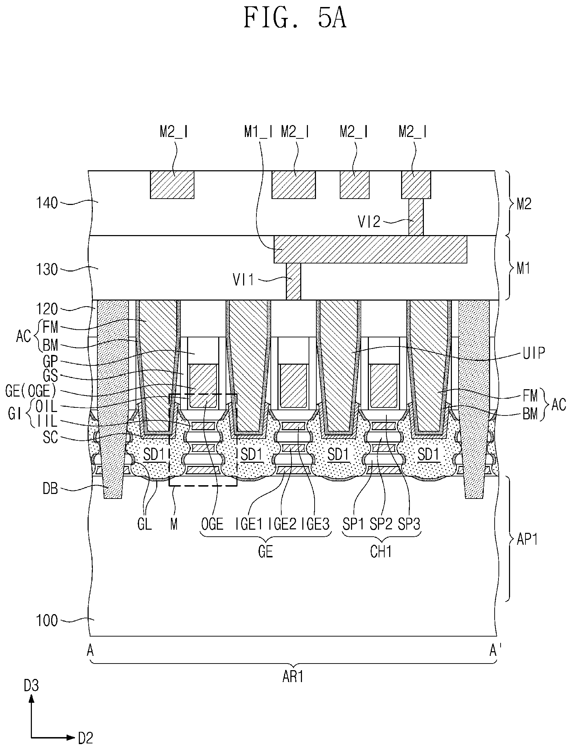

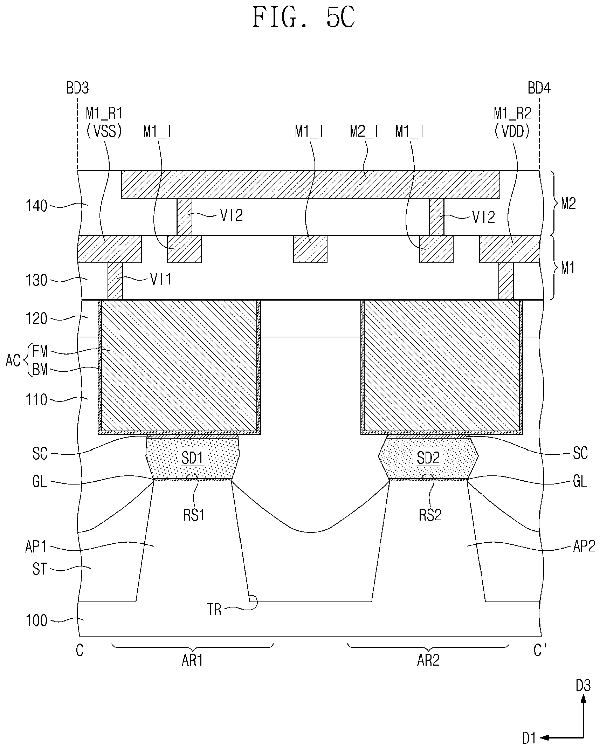

FIG. 4 is a plan view for illustrating a semiconductor device according to some embodiments of the disclosure. FIGS. 5A to 5D are cross-sectional views taken along lines A-A', B-B', C-C', and D-D' of FIG. 4, respectively. A semiconductor device shown in FIGS. 4 and 5A to 5D is an example that represents the single height cell SHC of FIG. 1.

Referring to FIGS. 4 and 5A to 5D, a single height cell SHC may be provided on a substrate 100. Logic transistors constituting a logic circuit may be disposed on the single height cell SHC. The substrate 100 may be a semiconductor substrate including silicon, germanium, silicon-germanium, or the like, or a compound semiconductor substrate. For example, the substrate 100 may be a silicon substrate.

The substrate 100 may include a first active region AR1 and a second active region AR2. Each of the first active region AR1and the second active region AR2 may extend in a second direction D2. In an embodiment, the first active region AR1 may be an NMOSFET region, and the second active region AR2 may be a PMOSFET region.

A first active pattern AP1 and a second active pattern AP2 may be defined by a trench TR formed on the substrate 100. The first active pattern AP1 may be provided on the first active region AR1, and the second active pattern AP2 may be provided on the second active region AR2. The first active pattern AP1 and the second active pattern AP2 may extend in the second direction D2. The first active pattern AP1 and the second active pattern AP2 may be a part of the substrate 100 and may be vertically protruding portions.

A device isolation layer ST may be provided on the substrate 100. The device isolation layer ST may fill the trench TR. The device isolation layer ST may include a silicon oxide layer. The device isolation layer ST may not cover first channel pattern CH1 and the second channel pattern CH2 to be described later.

A first channel pattern CH1 may be provided on the first active pattern AP1. A second channel pattern CH2 may be provided on the second active pattern AP2. Each of the first channel pattern CH1 and the second channel pattern CH2 may include a first semiconductor pattern SP1, a second semiconductor pattern SP2, and a third semiconductor pattern SP3 sequentially stacked. The first to third semiconductor patterns SP1, SP2, and SP3 may be spaced apart from one another in a vertical direction (i.e., a third direction D3).

Each of the first to third semiconductor patterns SP1, SP2, and SP3 may include silicon-germanium (SiGe). For example, each of the first to third semiconductor patterns SP1, SP2, and SP3 may include crystalline silicon. According to an embodiment, each of the first to third semiconductor patterns SP1, SP2, and SP3 may be stacked as nano sheets.

A plurality of first source/drain patterns SD1 may be provided on the first active pattern AP 1. A plurality of first recesses RS1 may be formed on the first active pattern AP 1. The first source/drain patterns SD1 may be respectively provided in the first recesses RS 1. The first source/drain patterns SD1 may be impurity regions of a first conductivity type (e.g., n-type). The first channel pattern CH1 may be interposed between a pair of first source/drain patterns SD1. That is, the stacked first to third semiconductor patterns SP1, SP2, and SP3 may connect the pair of first source/drain patterns SD1 to each other.

A plurality of second source/drain patterns SD2 may be provided on the second active pattern AP2. A plurality of second recesses RS2 may be formed on the second active pattern AP2. The second source/drain patterns SD2 may be respectively provided in the second recesses RS2. The second source/drain patterns SD2 may be impurity regions of a second conductivity type (e.g., p-type). The second channel pattern CH2 may be interposed between the pair of second source/drain patterns SD2. That is, the stacked first to third semiconductor patterns SP1, SP2, and SP3 may connect the pair of second source/drain patterns SD2 to each other.

The first source/drain pattern SD1 and the second source/drain pattern SD2 may be epitaxial patterns formed by a selective epitaxial growth (SEG) process. For example, a top surface of each of the first source/drain pattern SD1 and the second source/drain pattern SD2 may be higher than a top surface of the third semiconductor pattern SP3. As another example, the top surface of at least one of the first source/drain pattern SD1 and the second source/drain pattern SD2 may be positioned at substantially the same level as the top surface of the third semiconductor pattern SP3.

In an embodiment, the first source/drain patterns SD1 may include the same semiconductor element (e.g., Si) as the substrate 100. The second source/drain patterns SD2 may include a semiconductor element (e.g., SiGe) having a lattice constant greater than a lattice constant of the semiconductor element of the substrate 100. Accordingly, the pair of second source/drain patterns SD2 may provide a compressive stress to the second channel pattern CH2 therebetween.

A sidewall of each of the first source/drain pattern SD1 and the second source/drain pattern SD2 may have a rough embossing form. That is, the sidewall of each of the first source/drain pattern SD1 and the second source/drain pattern SD2 may have a wavy profile. The sidewalls of each of the first source/drain pattern SD1 and the second source/drain pattern SD2 may protrude toward first to third inner gate electrodes IGE1, IGE2, and IGE3 of a gate electrode GE, which will be described later.

Gate electrodes GE may be provided on the first channel pattern CH1 and the second channel pattern CH2. Each of the gate electrodes GE may cross the first channel pattern CH1 and the second channel pattern CH2 and may extend in a first direction D1. Each of the gate electrodes GE may vertically overlap the first channel pattern CH1 and the second channel pattern CH2. The gate electrodes GE may be arranged in the second direction D2 by a first pitch.

The gate electrode GE may include a first inner gate electrode IGE1 interposed between the active pattern AP1 or AP2 and the first semiconductor pattern SP1, a second inner gate electrode IGE2 interposed between the first semiconductor pattern SP1 and the second semiconductor pattern SP2, a third inner gate electrode IGE3 interposed between the second semiconductor pattern SP2 and the third semiconductor pattern SP3, and an outer gate electrode OGE4 on the third semiconductor pattern SP3.

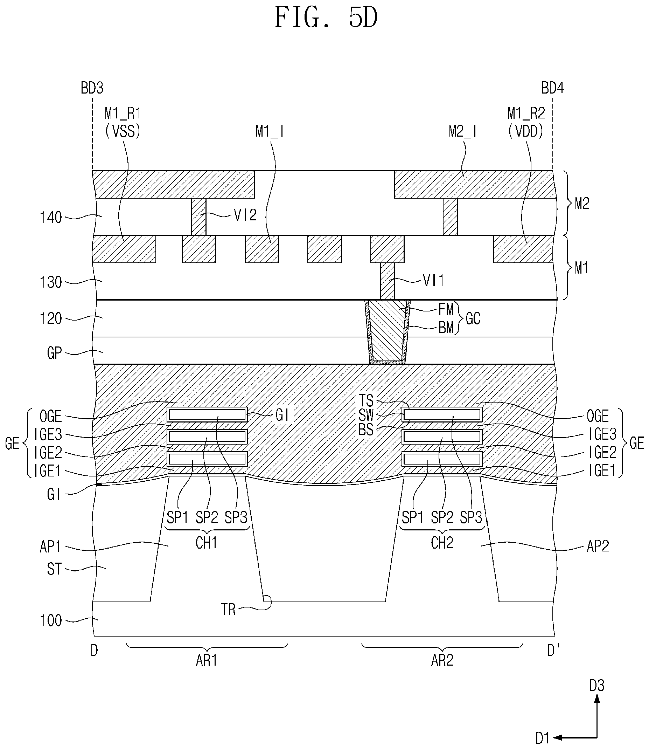

Referring to FIG. 5D, the gate electrode GE may be provided on a top surface TS, a bottom surface BS, and both sidewalls SW of each of the first to third semiconductor patterns SP1, SP2, and SP3. That is, a transistor according to the disclosure may be a three-dimensional field effect transistor (e.g., NMCFET or gate-all-around field-effect transistor (GAAFET)) in which the gate electrode GE surrounds the channel three-dimensionally.

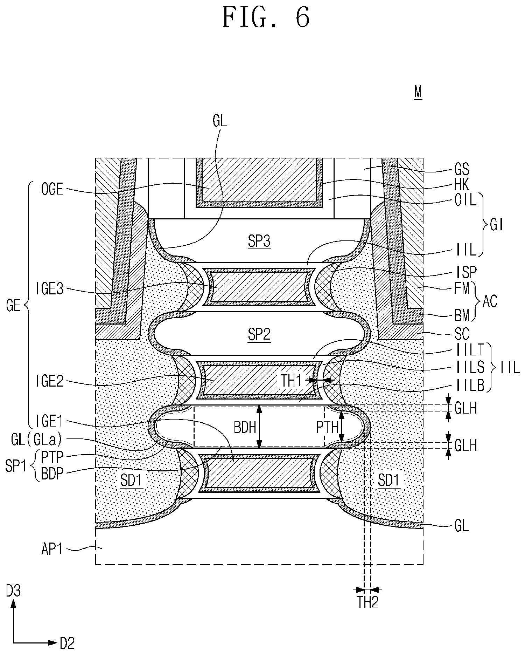

In an embodiment, inner spacers ISP may be interposed between the first to third inner gate electrodes IGE1, IGE2, and IGE3 of the gate electrode GE and the first source/drain pattern SD1, respectively, on the first active region AR1. In an embodiment, inner spacers ISP may be interposed between the first to third inner gate electrodes IGE1, IGE2, and IGE3 of the gate electrode GE and the second source/drain pattern SD2, respectively, on the second active region AR2. A detailed description of the inner spacer ISP according to the disclosure will be described later with reference to FIG. 6.

Referring back to FIGS. 4 and 5A to 5D, a pair of gate spacers GS may be respectively disposed on both sidewalls of the outer gate electrode OGE of the gate electrode GE. The gate spacers GS may extend in the first direction D1 along the gate electrode GE. Top surfaces of the gate spacers GS may be higher than a top surface of the gate electrode GE. The top surfaces of the gate spacers GS may be coplanar with a top surface of a first interlayer insulating layer 110 to be described later. In an embodiment, the gate spacers GS may include at least one of SiCN, SiCON, and SiN. In another embodiment, the gate spacers GS may include a multi-layer structure including at least two of SiCN, SiCON, and SiN.

A gate insulating layer GI may be interposed between the gate electrode GE and the first channel pattern CH1 and between the gate electrode GE and the second channel pattern CH2. The gate insulating layer GI may cover the top surface TS, bottom surface BS, and both sidewalls SW of each of the first to third semiconductor patterns SP1, SP2, and SP3. The gate insulating layer GI may cover the top surface of the device isolation layer ST below the gate electrode GE. The gate insulating layer GI may include an inner gate insulating layer IIL between the first to third semiconductor patterns SP1, SP2, and SP3 and the first to third inner gate electrodes IGE1, IGE2, and IGE3, and an outer gate insulating layer OIL between the third semiconductor pattern SP3 and the outer gate electrode OGE.

In one embodiment, the gate insulating layer GI may include a silicon oxide layer. Referring to FIG. 6, a high dielectric layer HK may be interposed between the gate electrode GE and the gate insulating layer GI. The high dielectric layer HK may surround the inner gate electrodes IGE1, IGE2, and IGE3 of the gate electrodes GE with a uniform thickness. The high dielectric layer HK may extend from a bottom surface to a side surface of the outer gate electrode OGE of the gate electrode GE. For example, the gate insulating layer GI may have a structure stacked on the high dielectric layer HK.

The high dielectric layer HK (e.g., see FIG. 6) may include a high dielectric constant material that has a higher dielectric constant than that of a silicon oxide layer. As an example, the high dielectric constant material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In another embodiment, the semiconductor device may include a negative capacitance (NC) FET using a negative capacitor. For example, the gate insulating layer GI may include a ferroelectric material layer having ferroelectric properties and a paraelectric material layer having paraelectric properties.

The ferroelectric material layer may have a negative capacitance, and the paraelectric material layer may have a positive capacitance. For example, when two or more capacitors are connected in series and a capacitance of each capacitor has a positive value, the total capacitance is decreased to less than a capacitance of each individual capacitor. On the other hand, when at least one of the capacitances of two or more capacitors connected in series has a negative value, the total capacitance may have a positive value and be greater than an absolute value of each individual capacitance.

When a ferroelectric material layer having a negative capacitance and a paraelectric material layer having a positive capacitance are connected in series, the total capacitance of the ferroelectric material layer and the paraelectric material layer connected in series may increase. By using the increase in the total capacitance value, the transistor including the ferroelectric material layer may have a subthreshold swing (SS) of less than 60 mV/decade at room temperature.

The ferroelectric material layer may have ferroelectric properties. The ferroelectric material layer may include, for example, at least one of hafnium oxide, hafnium zirconium oxide, barium strontium titanium oxide, barium titanium oxide, and lead zirconium titanium oxide. Here, as an example, hafnium zirconium oxide may be a material in which hafnium oxide is doped with zirconium (Zr). As another example, hafnium zirconium oxide may be a compound of hafnium (Hf), zirconium (Zr), and oxygen (O).

The ferroelectric material layer may further include a doped dopant. For example, dopants may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). A type of dopant included in the ferroelectric material layer may be variously changed depending on which ferroelectric material the ferroelectric material layer includes.

When the ferroelectric material layer includes hafnium oxide, the dopant included in the ferroelectric material layer may include, for example, at least one of gadolinium (Gd), silicon (Si), zirconium (Zr), aluminum (Al), and yttrium (Y).

When the dopant is aluminum (Al), the ferroelectric material layer may include 3 to 8 atomic% (at%) of aluminum. Here, a ratio of the dopant may be a ratio of aluminum to the sum of hafnium and aluminum.

When the dopant is silicon (Si), the ferroelectric material layer may include about 2 to about 10 at% of silicon. When the dopant is yttrium (Y), the ferroelectric material layer may include about 2 to about 10 at% of yttrium. When the dopant is gadolinium (Gd), the ferroelectric material layer may include about 1 to about 7 at% gadolinium. When the dopant is zirconium (Zr), the ferroelectric material layer may include about 50 to about 80 at% of zirconium.

The paraelectric material layer may have paraelectric properties. The paraelectric material layer may include, for example, at least one of silicon oxide and a metal oxide having a high dielectric constant. The metal oxide included in the paraelectric material layer may include, for example, at least one of hafnium oxide, zirconium oxide, and aluminum oxide, but is not limited thereto.

The ferroelectric material layer and the paraelectric material layer may include the same material. The ferroelectric material layer may have ferroelectric properties, but the paraelectric material layer may not have ferroelectric properties. For example, when the ferroelectric material layer and the paraelectric material layer include hafnium oxide, a crystal structure of hafnium oxide included in the ferroelectric material layer is different from a crystal structure of hafnium oxide included in the paraelectric material layer.

The ferroelectric material layer may have a thickness having ferroelectric properties. The thickness of the ferroelectric material layer may be, for example, about 0.5 to about 10 nm, but is not limited thereto. A critical thickness representing the ferroelectric properties may be variously changed for each ferroelectric material, the thickness of the ferroelectric material layer may vary depending on the ferroelectric material.

As an example, the gate insulating layer GI may include one ferroelectric material layer. As another example, the gate insulating layer GI may include a plurality of ferroelectric material layers spaced apart from one another. The gate insulating layer GI may have a stacked structure in which a plurality of ferroelectric material layers and a plurality of paraelectric material layers are alternately stacked.

Referring back to FIGS. 4 and 5A to 5D, the gate electrode GE may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work function metal that adjusts a threshold voltage of the transistor. A desired threshold voltage of the transistor may be achieved by adjusting a thickness and composition of the first metal pattern. For example, the first to third inner gate electrodes IGE1, IGE2, and IGE3 of the gate electrode GE may be formed of the first metal pattern that is a work function metal.

The first metal pattern may include a metal nitride layer. For example, the first metal pattern may include at least one metal selected from the group consisting of titanium (Ti), tantalum (Ta), aluminum (Al), tungsten (W), and molybdenum (Mo), and nitrogen (N). Furthermore, the first metal pattern may further include carbon (C). The first metal pattern may include a plurality of stacked work function metal layers.

The second metal pattern may include a metal having a lower resistance than a resistance of the first metal pattern. For example, the second metal pattern may include at least one metal selected from the group consisting of tungsten (W), aluminum (Al), titanium (Ti), and tantalum (Ta). For example, the outer gate electrode OGE of the gate electrode GE may include the first metal pattern and the second metal pattern on the first metal pattern.

A first interlayer insulating layer 110 may be provided on the substrate 100. The first interlayer insulating layer 110 may cover the gate spacers GS and the first source/drain pattern SD1 and the second source/drain pattern SD2. A top surface of the first interlayer insulating layer 110 may be substantially coplanar with a top surface of the gate capping pattern GP and a top surface of the gate spacer GS. A second interlayer insulating layer 120 covering the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, the first to fourth interlayer insulating layers 110 to 140 may include a silicon oxide layer.

The single height cell SHC may have a first boundary BD1 and a second boundary BD2 opposite to each other in the second direction D2. The first boundary BD1 and the second boundary BD2 may extend in the first direction D1. The single height cell SHC may have a third boundary BD3 and a fourth boundary BD4 opposite to each other in the first direction D1. The third boundary BD3 and the fourth boundary BD4 may extend in the second direction D2.

The separation structure DB may pass through the first and second interlayer insulating layers 110 and 120 and extend into the first active pattern AP1 and the second active pattern AP2. The separation structure DB may pass through each of the first active pattern AP1 and the second active pattern AP2. The separation structure DB may electrically isolate an active region of the single height cell SHC from an active region of another adjacent cell.

Active contacts AC may be provided through the first and second interlayer insulating layers 110 and 120 and electrically connected to the first source/drain pattern SD1 and the second source/drain pattern SD2, respectively. A pair of active contacts AC may be provided on both sides of the gate electrode GE, respectively. When viewed in a plan view, the active contact AC may have a bar shape extending in the first direction D1.

The active contact AC may be a self-aligned contact. That is, the active contact AC may be formed in a self-aligned manner using the gate capping pattern GP and the gate spacer GS. For example, the active contact AC may cover at least a part of a sidewall of the gate spacer GS. In an embodiment, the active contact AC may partially cover the top surface of the gate capping pattern GP.

A metal-semiconductor compound layer SC, such as a silicide layer, may be respectively interposed between the active contact AC and the first source/drain pattern SD1 and between the active contact AC and the second source/drain pattern SD2, respectively. The active contact AC may be electrically connected to the source/drain patterns SD1 and SD2 through the metal-semiconductor compound layer SC. For example, the metal-semiconductor compound layer SC may include at least one of titanium-silicide, tantalum-silicide, tungsten-silicide, nickel-silicide, and cobalt-silicide.

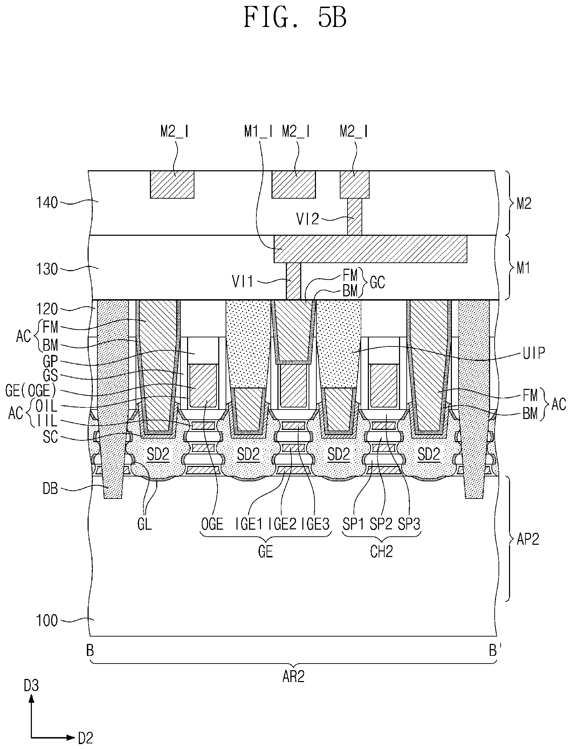

Gate contacts GC may be provided through the second interlayer insulating layer 120 and the gate capping pattern GP to be electrically connected to the gate electrodes GE, respectively. When viewed in a plan view, the gate contacts GC may be disposed to overlap the first active region AR1 and the second active region AR2, respectively. For example, the gate contact GC may be provided on the second active pattern AP2 (refer to FIG. 5B).

In an embodiment, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. That is, a top surface of the active contact AC adjacent to the gate contact GC may descend lower than a bottom surface of the gate contact GC by the upper insulating pattern UIP. Accordingly, a problem in that the gate contact GC comes into contact with the active contact AC adjacent thereto and a short circuit occurs may be reduced or prevented.

Each of the active contact AC and the gate contact GC may include a conductive pattern FM and a barrier pattern BM surrounding the conductive pattern FM. For example, the conductive pattern FM may include at least one of aluminum, copper, tungsten, molybdenum, and cobalt. The barrier pattern BM may cover sidewalls and a bottom surface of the conductive pattern FM. The barrier pattern BM may include a metal layer/metal nitride layer. The metal layer may include at least one of titanium, tantalum, tungsten, nickel, cobalt, and platinum. The metal nitride layer may include at least one of a titanium nitride layer (TiN), a tantalum nitride layer (TaN), a tungsten nitride layer (WN), a nickel nitride layer (NiN), a cobalt nitride layer (CoN), and a platinum nitride layer (PtN).

A first metal layer M1 may be provided in the third interlayer insulating layer 130. For example, the first metal layer M1 may include a first power wiring M1_R1, a second power wiring M1_R2, and first wirings M1_I. Each of the wirings M1_R1, M1_R2, and M1_I of the first metal layer M1 may extend parallel to one another in the second direction D2.

In an embodiment, the first and second power wirings M1_R1 and M1_R2 may be provided on the third and fourth boundaries BD3 and BD4 of the single height cell SHC, respectively. The first power wiring M1_R1 may extend in the second direction D2 along the third boundary BD3. The second power wiring M1_R2 may extend in the second direction D2 along the fourth boundary BD4.

The first wirings M1_I of the first metal layer M1 may be disposed between the first and second power wirings M1_R1 and M1_R2. The first wirings M1_I of the first metal layer M1 may be arranged in the first direction D1 at a second pitch. The second pitch may be smaller than the first pitch. A line width of each of the first wirings M1_I may be smaller than a line width of each of the first and second power wirings M1_R1 and M1_R2.

The first metal layer M1 may further include first vias VI1. The first vias VI1 may be respectively provided under the wirings M1_R1, M1_R2, and M1_I of the first metal layer M1. The active contact AC and the wiring of the first metal layer M1 may be electrically connected to each other through the first via VI1. The gate contact GC and the wiring of the first metal layer M1 may be electrically connected to each other through the first via VI1.

The wiring of the first metal layer M1 and the first via VI1 under the wiring of the first metal layer M1 may be formed through separate processes. That is, each of the wiring and the first via VI1 of the first metal layer M1 may be formed by a single damascene process. The semiconductor device according to the disclosure may be formed using a process of less than 20 nm.

A second metal layer M2 may be provided in the fourth interlayer insulating layer 140. The second metal layer M2 may include a plurality of second wirings M2_I. Each of the second wirings M2_I of the second metal layer M2 may have a line shape or a bar shape extending in the first direction D1. That is, the second wirings M2_I may extend parallel to one another in the first direction D 1.

The second metal layer M2 may further include second vias VI2 respectively provided under the second wirings M2_I. The wiring of the first metal layer M1 and the wiring of the second metal layer M2 may be electrically connected to each other through the second via VI2. For example, the wiring of the second metal layer M2 and the second via VI2 under the wiring of the second metal layer M2 may be formed together by a dual damascene process.

The wiring of the first metal layer M1 and the wiring of the second metal layer M2 may include the same or different conductive materials. For example, the wiring of the first metal layer M1 and the wiring of the second metal layer M2 may include at least one metal material selected from aluminum, copper, tungsten, molybdenum, ruthenium, and cobalt. In an embodiment, metal layers (e.g., M3, M4, M5...) stacked on the fourth interlayer insulating layer 140 may be additionally disposed. Each of the stacked metal layers may include wirings for routing between cells.

FIG. 6 is an enlarged view illustrating an example of region 'M' of FIG. 5A. Referring to FIG. 6, the gate insulating layer GI, inner spacer ISP, high dielectric layer HK, and first to third semiconductor patterns SP1, SP2, and SP3 will be described.

The gate electrode GE may include a first inner gate electrode IGE1, a second inner gate electrode IGE2, a third inner gate electrode IGE3, and an outer gate electrode OGE. The gate insulating layer GI may include a silicon oxide layer. The gate insulating layer GI may include an inner gate insulating layer III, on each of the first to third inner gate electrodes IGE1, IGE2, and IGE3 and an outer gate insulating layer OIL on the outer gate electrode OGE. The outer gate insulating layer OIL may be provided on a bottom surface and side surfaces of the outer gate electrode OGE. The outer gate insulating layer OIL may extend to the gate capping pattern GP (e.g., see FIG. 5A) covering a top surface of the outer gate electrode OGE.

The inner gate insulating layer III, may be provided between the first to third semiconductor patterns SP1, SP2, and SP3 and the first to third inner gate electrodes IGE1, IGE2, and IGE3. For example, the inner gate insulating layer III, may surround the first to third inner gate electrodes IGE1, IGE2, and IGE3.

In an embodiment, the inner gate insulating layer III, may include an upper insulating layer IILT between the first inner gate electrode IGE1 and the first semiconductor pattern SP1, a lower insulating layer IILB between the first inner gate electrode IGE1 and the first active pattern AP1, and a side insulating layer IILS between the first inner gate electrode IGE1 and the inner spacer ISP.

The inner gate insulating layer IIL may include an upper insulating layer IILT between the second inner gate electrode IGE2 and the second semiconductor pattern SP2, and a lower insulating layer IILB between the second inner gate electrode IGE2 and the first semiconductor pattern SP1, and a side insulating layer IILS between the second inner gate electrode IGE2 and the inner spacer ISP.

The inner gate insulating layer IIL may include an upper insulating layer IILT between the third inner gate electrode IGE3 and the third semiconductor pattern SP3, and a lower insulating layer IILB between the third inner gate electrode IGE3 and the second semiconductor pattern SP2, and a side insulating layer IILS between the third inner gate electrode IGE3 and the inner spacer ISP.

The inner gate insulating layer IIL may include a different material from the inner spacer ISP. The inner gate insulating layer IIL may have an etch selectivity with respect to the inner spacer ISP. For example, the inner gate insulating layer IIL may include silicon oxide (SiO), and the inner spacer ISP may include silicon nitride (SiN). An interface between the inner gate insulating layer IIL and the inner spacer ISP may be identified.

Each of the first to third semiconductor patterns SP1, SP2, and SP3 may include a body portion BDP and a protrusion PTP protruding from the body portion BDP in the second direction D2 toward the first source/drain pattern SD1. A silicon layer GL may be formed covering an outer wall of the protrusion PTP. The silicon layer GL may be interposed between the protrusion PTP and the first source/drain pattern SD1. The silicon layer GL may be epitaxial patterns formed from the protrusion PTP through an epitaxial growth process.

The silicon layer GL may also be interposed between the first active pattern AP1 and the first source/drain pattern SD1. The silicon layer GL may be in contact with the inner spacer ISP and the inner gate insulating layer IIL. A thickness of the silicon layer GL may be constant. A first thickness TH1 of the side insulating layer IILS of the inner gate insulating layer IILS may be equal to a second thickness TH2 of the silicon layer GL. The first thickness TH1 may be defined as the shortest distance between one side surface of the side insulating layer IILS and one side surface of the inner spacer ISP. The second thickness TH2 may be defined as the shortest distance between a side surface of the first source/drain pattern SD1 and the protrusion PTP. The first thickness TH1 and the second thickness TH2 may be a distance in the second direction D2.

The highest level of the body portion BDP may be substantially the same as the highest level of the silicon layer GL. For example, the highest portion of the body BDP may be positioned at the same level as the highest portion of the silicon layer GL. The lowest level of the body portion BDP may be substantially the same as the lowest level of the silicon layer GL. For example, the lowest portion of the body BDP may be positioned at the same level as the lowest portion of the silicon layer GL.

The body BDP may have a body thickness BDH in the third direction D3. The protrusion PTP may have a protrusion thickness PTH in the third direction D3. The body thickness BDH may be greater than the protrusion thickness PTH. The body thickness BDH may be equal to the sum of the protrusion thickness PTH and a thickness GLH of the silicon layer GL covering the protrusion. The thickness GLH of the silicon layer GL may be a length in the third direction D3. By forming the silicon layer GL on the protrusion PTP, a thickness of the first to third semiconductor patterns SP1, SP2, and SP3 in the third direction D3 may be constant.

The high dielectric layer HK may be interposed between the inner gate electrodes IGE1, IGE2, and IGE3 and the inner gate insulating layer III, or between the outer gate electrode OGE and the outer gate insulating layer OIL. The high dielectric layer HK may be provided on the inner gate electrodes IGE1, IGE2, and IGE3, and the inner gate insulating layer IIL may be provided on the high dielectric layer HK. The high dielectric layer HK may be conformally formed.

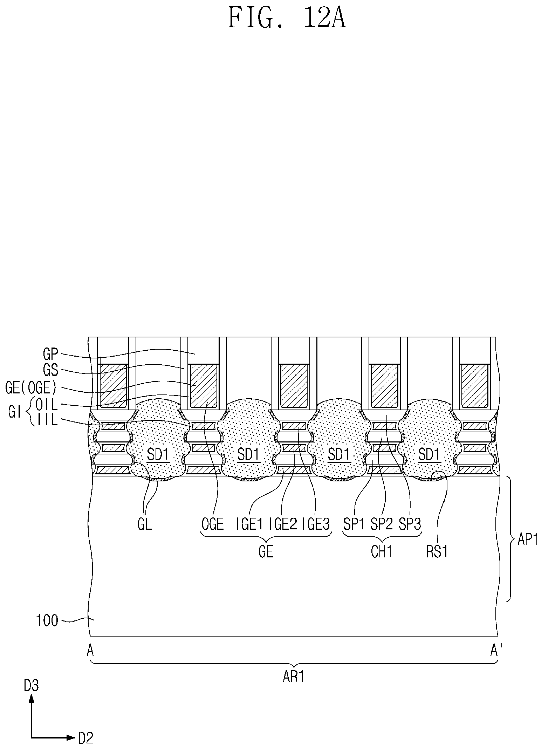

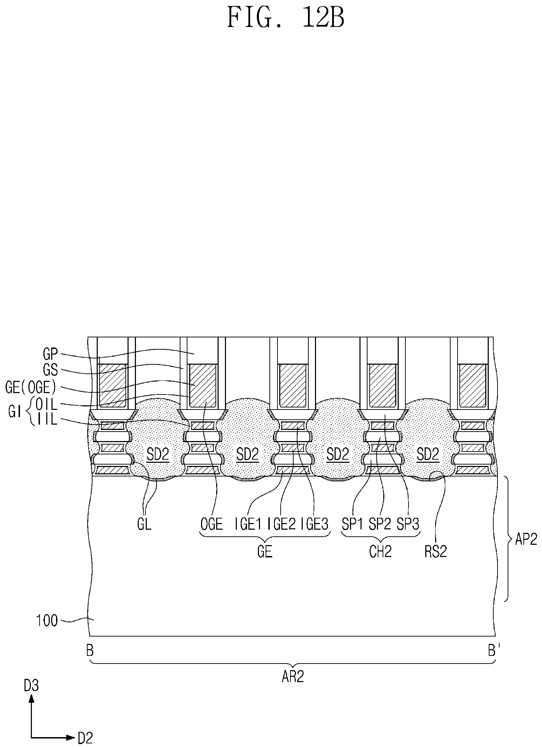

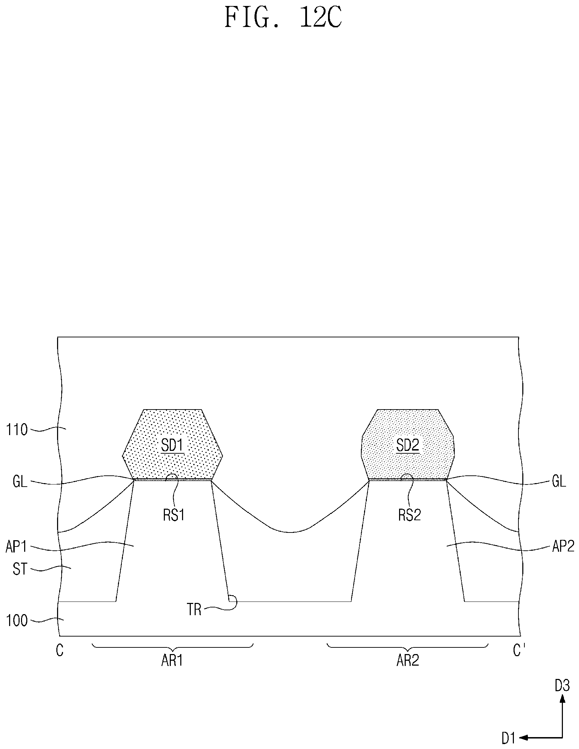

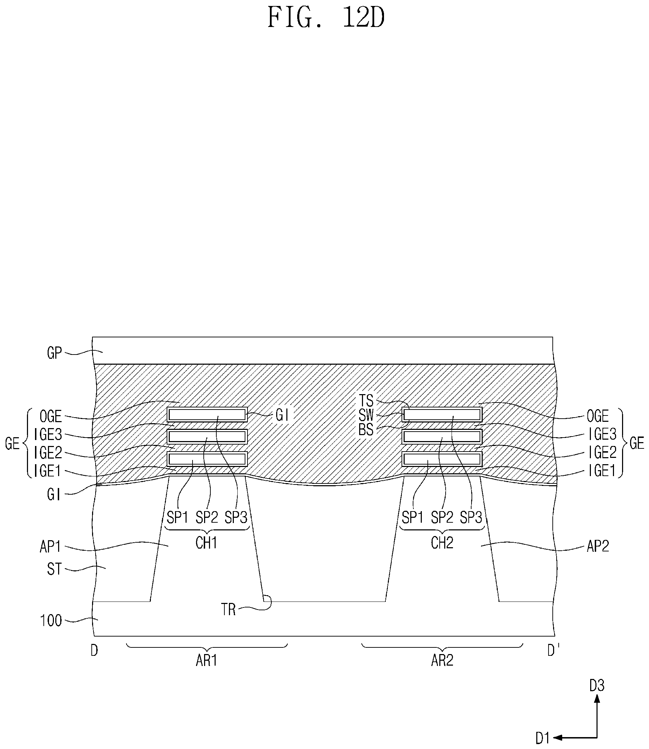

According to the semiconductor device manufacturing method described later, the silicon layer GL may be formed on a first recess RS1 (e.g., see FIG. 12A) and a second recess RS2 (e.g., see FIG. 12B) before the inner spacer ISP is formed. The silicon layer GL may include a first portion GLa on the first to third semiconductor patterns SP1, SP2, and SP3 and a second portion GLb on the sacrificial layer. The second portion GLb may be oxidized through an oxidation process described later to form the side insulating layer IILS of the inner gate insulating layer IIL. The inner gate insulating layer III, may prevent leakage current together with the inner spacer ISP.

According to the disclosure, a thickness difference between the body BDP and the protrusion PTP may be minimized by providing the silicon layer GL on the protrusion PTP. By forming the silicon layer GL, the thickness of the semiconductor patterns SP1, SP2, and SP3 may be constant. Accordingly, resistance due to a decrease in the thickness of the semiconductor patterns SP1, SP2, and SP3 may be minimized. As a result, electrical characteristics of the semiconductor device according to the disclosure may be improved.

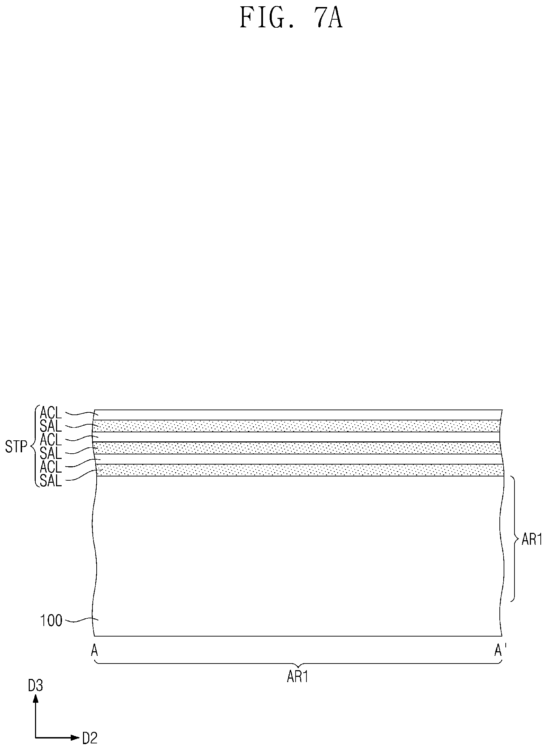

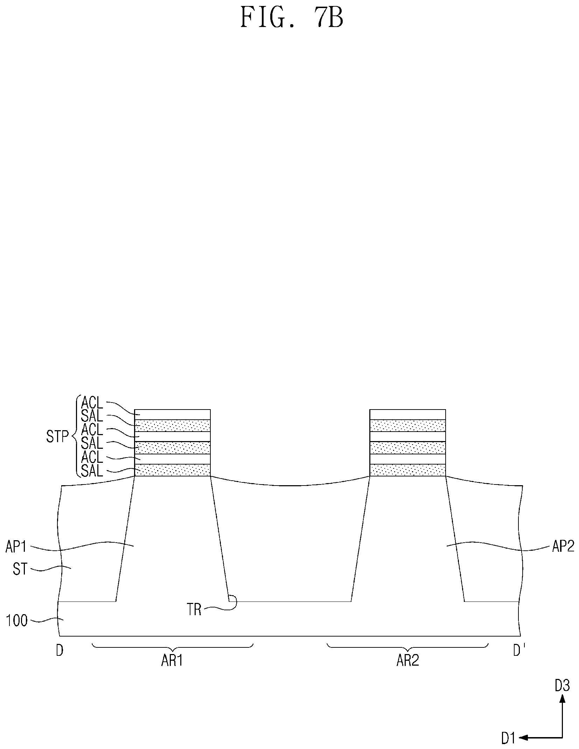

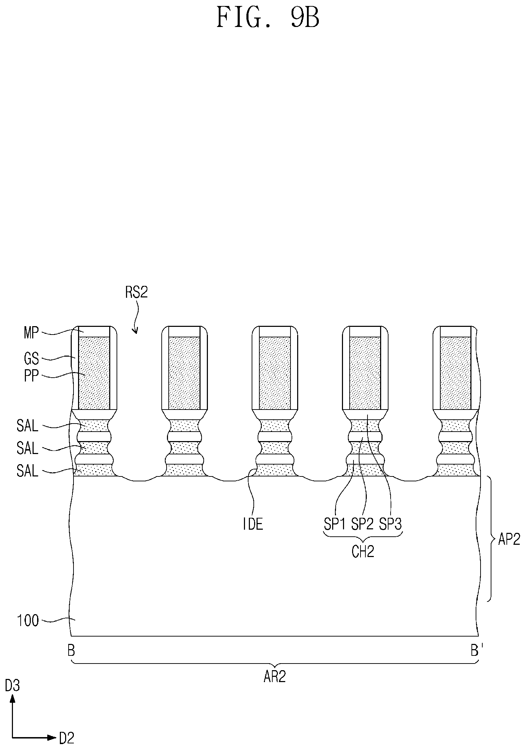

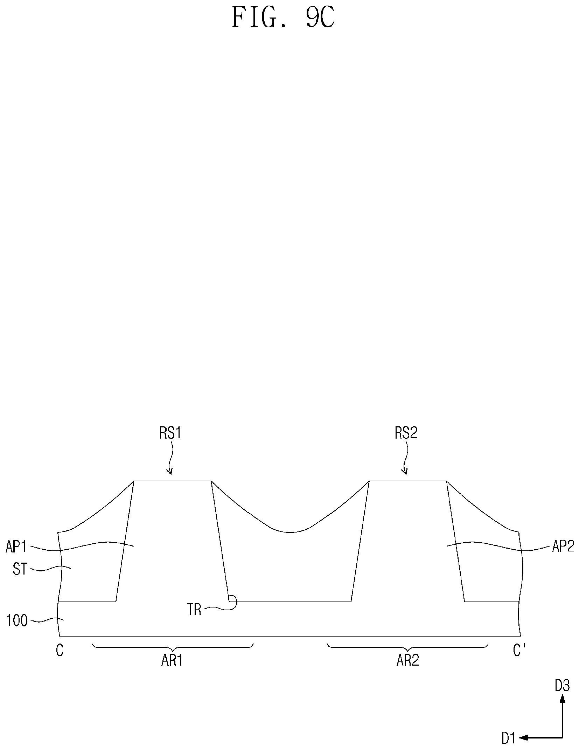

FIGS. 7A to 12D are cross-sectional views for illustrating a method of manufacturing a semiconductor device according to embodiments of the disclosure. In an embodiment, FIGS. 7A, 8A, 9A, 10A, 11A, and 12A are cross-sectional views corresponding to line A-A' in FIG. 4. FIGS. 9B, 10B, 11B, and 12B are cross-sectional views corresponding to line B-B' in FIG. 4. FIGS. 9C, 10C, 11C, and 12C are cross-sectional views corresponding to line C-C' in FIG. 4. FIGS. 7B, 8B, 11D, and 12D are cross-sectional views corresponding to line D-D' in FIG. 4. Hereinafter, a manufacturing method according to embodiments of the disclosure will be described with reference to FIGS. 7A to 12D.

Referring to FIGS. 7A and 7B, a substrate 100 includes the first active region AR1 and the second active region AR2. Active layers ACL and sacrificial layers SAL may be alternately stacked on the substrate 100. The active layers ACL may include one of silicon (Si), germanium (Ge), and silicon-germanium (SiGe), and the sacrificial layers SAL may include another one of silicon (Si), germanium (Ge), and silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). A concentration of germanium (Ge) in each of the sacrificial layers SAL may be 10 at% to 30 at%.

Mask patterns may be respectively formed on the first active region AR1 and the second active region AR2 of the substrate 100. The mask pattern may have a line shape or a bar shape extending in a second direction D2.

A patterning process may be performed using the mask patterns as an etch mask to from a trench TR defining a first active pattern AP1 and a second active pattern AP2. The first active pattern AP1 may be formed on the first active region AR1. The second active pattern AP2 may be formed on the second active region AR2.

A stacked pattern STP may be formed on each of the first active pattern AP1 and the second active pattern AP2. The stacked pattern STP may include active layers ACL and sacrificial layers SAL that are alternately stacked. The stacked pattern STP may be formed together with the first active pattern AP1 and the second active pattern AP2 during the patterning process.

A device isolation layer ST filling the trench TR may be formed. In an embodiment, an insulating layer covering the first active pattern AP1 and the second active pattern AP2 and the stacked patterns STP may be formed on an entire surface of the substrate 100. The insulating layer may be recessed until the stacked patterns STP are exposed, to form the device isolation layer ST.

The device isolation layer ST may include an insulating material such as a silicon oxide layer. The stacked patterns STP may be exposed on the device isolation layer ST. That is, the stacked patterns STP may protrude vertically above the device isolation layer ST.

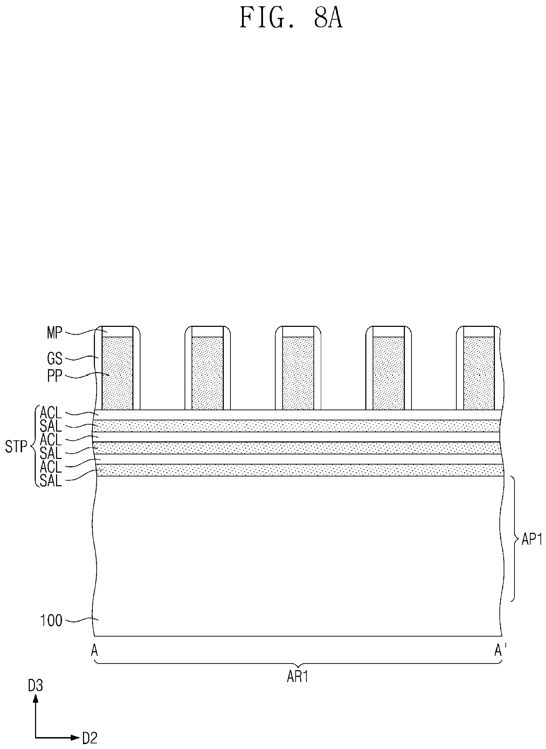

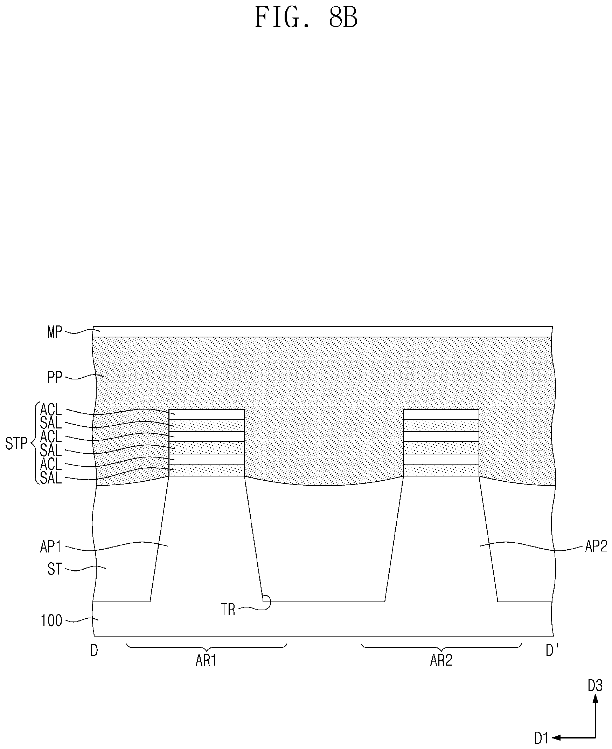

Referring to FIGS. 8A and 8B, sacrificial patterns PP crossing the stacked patterns STP may be formed on the substrate 100. Each of the sacrificial patterns PP may be formed in a line shape or a bar shape extending in a first direction D1. The sacrificial patterns PP may be arranged in the second direction D2 at a first pitch.

In an embodiment, forming the sacrificial patterns PP may include forming a sacrificial layer on the entire surface of the substrate 100, forming hard mask patterns MP on the sacrificial layer, and patterning the sacrificial layer using the hard mask patterns MP as an etch mask. The sacrificial layer may include polysilicon.

A pair of gate spacers GS may be formed on both sidewalls of each of the sacrificial patterns PP. Forming the gate spacers GS may include conformally forming a gate spacer layer on the entire surface of the substrate 100 and anisotropically etching the gate spacer layer. In an embodiment, the gate spacer GS may be a multi-layer structure including at least two layers.

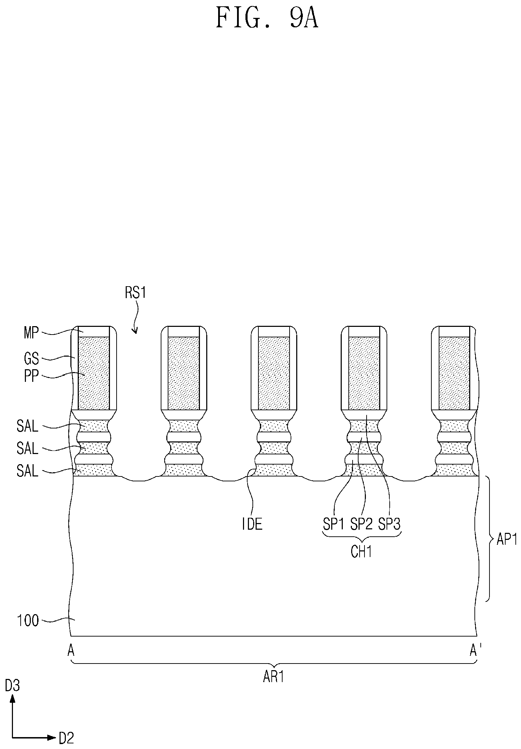

Referring to FIGS. 9A to 9C, first recesses RS1 may be formed in the stacked pattern STP on the first active pattern AP1. Second recesses RS2 may be formed in the stacked pattern STP on the second active pattern AP2. While the first recesses RS1 and the second recesses RS2 are formed, the device isolation layer ST on both sides of each of the first active pattern AP1 and the second active pattern AP2 may be further recessed (refer to FIG. 9B).

In an embodiment, the stacked pattern STP on the first active pattern AP1 may be etched using the hard mask patterns MP and the gate spacers GS as an etch mask to form the first recesses RS1. The first recess RS1 may be formed between the pair of sacrificial patterns PP.

In an embodiment, forming the first recess RS1 may include additionally performing a selective etching process on the exposed sacrificial layers SAL. Each of the sacrificial layers SAL may be indented through the selective etching process to form an indented region IDE. Accordingly, the first recess RS 1 may have a wavy inner wall. Sidewalls of the sacrificial layers SAL may be concave by the indented region IDE. The second recesses RS2 in the stacked pattern STP on the second active pattern AP2 may be formed in the same manner as the first recesses RS1.

First to third semiconductor patterns SP1, SP2, and SP3 sequentially stacked between adjacent first recesses RS1 may be formed from the active layers ACL, respectively. The first to third semiconductor patterns SP1, SP2, and SP3 between adjacent first recesses RS 1 may form a first channel pattern CH1. The first to third semiconductor patterns SP1, SP2, and SP3 between adjacent second recesses RS2 may form a second channel pattern CH2.

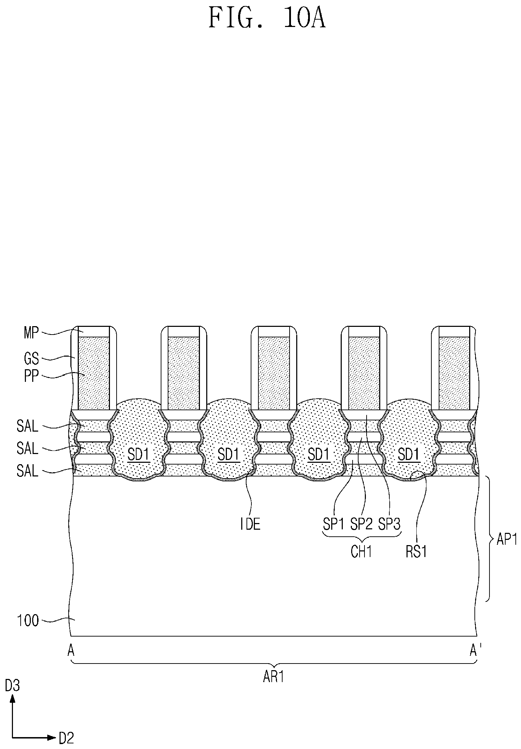

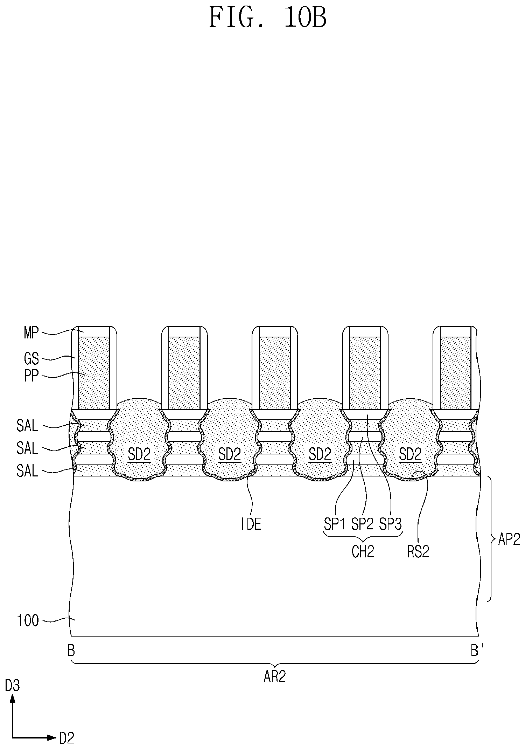

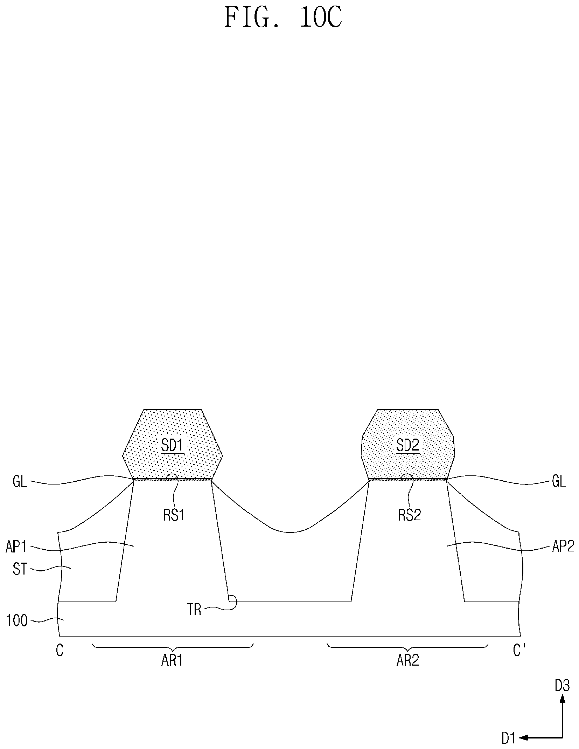

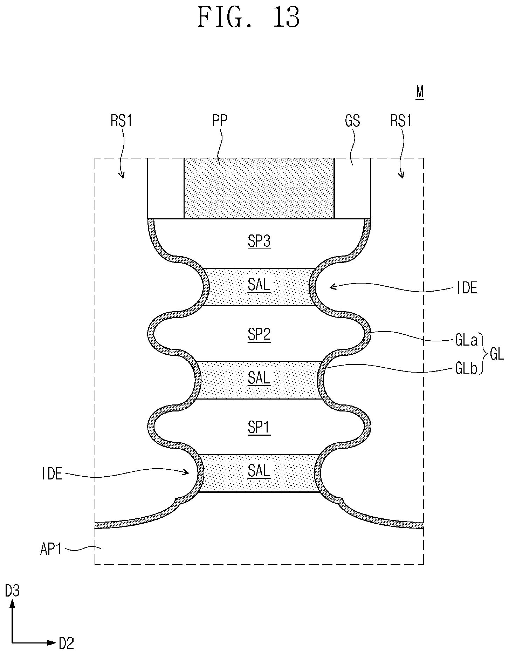

Referring to FIGS. 10A to 10C, a silicon layer GL may be formed in the first recesses RS1. The silicon layer GL will be described in detail later with reference to FIGS. 13 to 17.

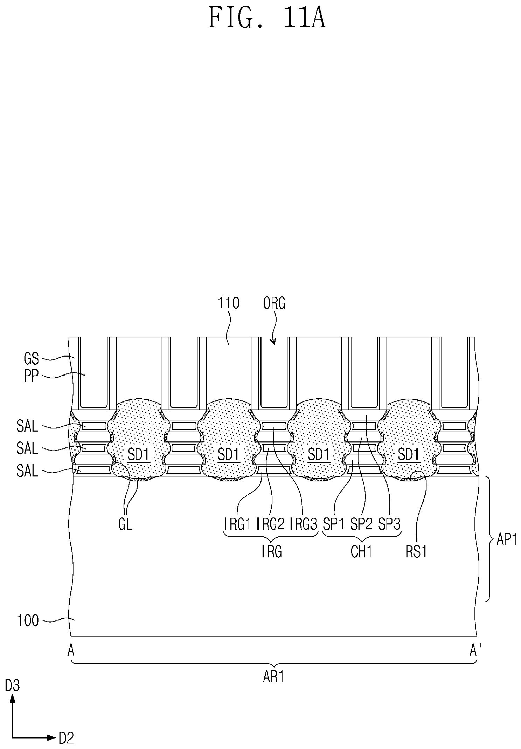

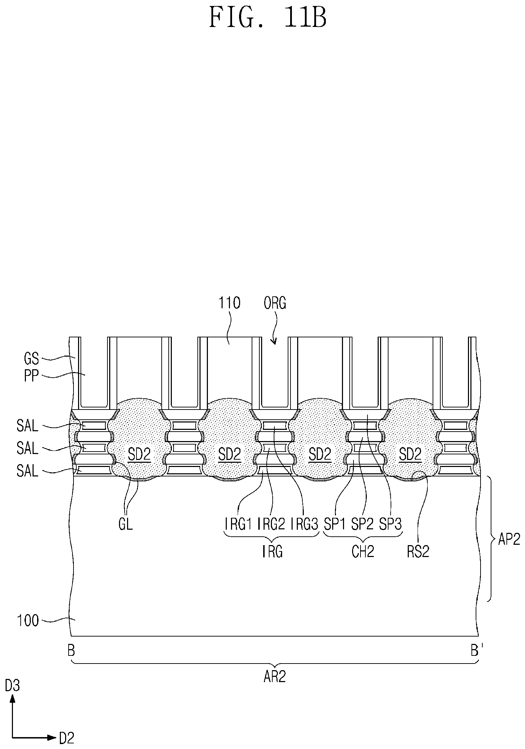

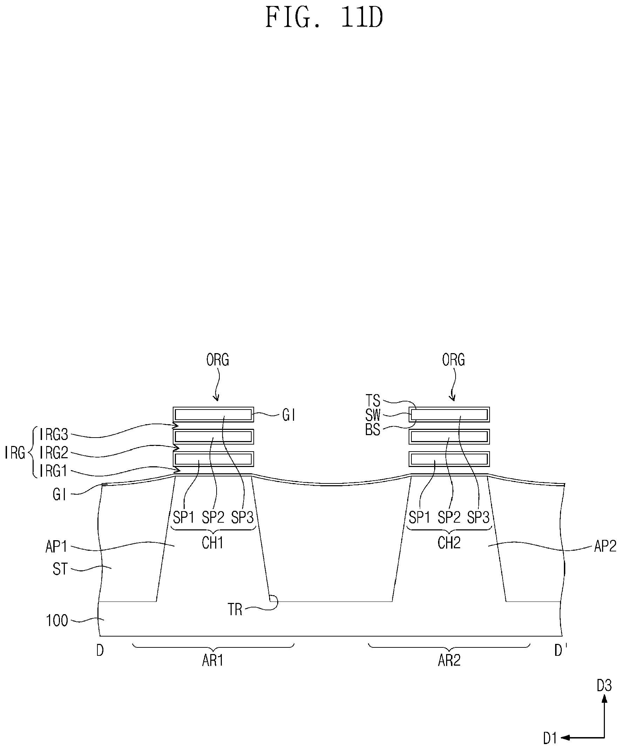

Referring to FIGS. 11A to 11C, the exposed sacrificial patterns PP may be selectively removed and a gate insulating layer GI may be formed. A gate insulating layer GI may be formed on the exposed first to third semiconductor patterns SP1, SP2, and SP3. The gate insulating layer GI may be formed to surround each of the first to third semiconductor patterns SP1, SP2, and SP3. An inner gate insulating layer IIL may be formed in the first to third inner regions IRG1, IRG2, and IRG3, which will be described later. An outer gate insulating layer OIL may be formed in the outer region ORG. Forming the gate insulating layer GI will be described in detail later with reference to FIGS. 13 to 17.

Referring to FIGS. 12A to 12D, a gate electrode GE may be formed on the gate insulating layer GI. The gate electrode GE may include the first to third inner gate electrodes IGE1, IGE2, and IGE3 that are respectively formed in the first to third inner regions IRG1, IRG2, and IRG3, and an outer gate electrode OGE that is formed in the outer region ORG. The gate electrode GE may be recessed, thereby reducing a height thereof. A gate capping pattern GP may be formed on the recessed gate electrode GE.

Referring again to FIGS. 5A to 5D, a second interlayer insulating layer 120 may be formed on the first interlayer insulating layer 110. The second interlayer insulating layer 120 may include a silicon oxide layer. Active contacts AC electrically connected to the first source/drain pattern SD1 and the second source/drain pattern SD2 may be formed through the second interlayer insulating layer 120 and the first interlayer insulating layer 110. A gate contact GC electrically connected to the gate electrode GE may be formed through the second interlayer insulating layer 120 and the gate capping pattern GP.

The forming of each of the active contact AC and the gate contact GC may include forming a barrier pattern BM and forming a conductive pattern FM on the barrier pattern BM. The barrier pattern BM may be conformally formed and may include a metal layer/metal nitride layer. The conductive pattern FM may include a low-resistance metal.

Separation structures DB may be respectively formed on the first boundary BD1 and the second boundary BD2 of the single height cell SHC. The separation structure DB may extend into the first active pattern AP1 or the second active pattern AP2 from the second interlayer insulating layer 120 through the gate electrode GE. The separation structure DB may include an insulating material such as a silicon oxide layer or a silicon nitride layer.

A third interlayer insulating layer 130 may be formed on the active contacts AC and the gate contacts GC. A first metal layer M1 may be formed in the third interlayer insulating layer 130. A fourth interlayer insulating layer 140 may be formed on the third interlayer insulating layer 130. A second metal layer M2 may be formed in the fourth interlayer insulating layer 140.

Hereinafter, a formation process of the gate insulating layer GI will be described with reference to FIGS. 13 to 17. For simplicity of explanation, descriptions that overlap with the above are omitted. FIGS. 13 to 17 are diagrams illustrating a method of manufacturing the semiconductor device according to FIG. 6 and are enlarged views for illustrating the method of forming region 'M' of FIG. 5A.

Referring to FIG. 13, a silicon layer GL may be formed in the first recesses RS1. The silicon layer GL may be formed in the indent region IDE. The silicon layer GL may be formed on the first active pattern AP1 of the substrate 100.

The silicon layer GL may include a first portion GLa on the first to third semiconductor patterns SP1, SP2, and SP3 and a second portion GLb on the sacrificial layers SAL. The first portion GLa may cover outer walls of the first to third semiconductor patterns SP1, SP2, and SP3 exposed by the first recess RS1. The second portion GLb may cover an outer wall of the sacrificial layers SAL exposed by the indent region IDE. The silicon layer GL may not be formed on the gate spacer GS.

Forming the silicon layer GL may include performing an epitaxial growth process on the first to third semiconductor patterns SP1, SP2, and SP3, the first active pattern AP1, and the sacrificial layers SAL. The silicon layer GL may be grown using the first to third semiconductor patterns SP1, SP2, and SP3, the first active pattern AP1, and the sacrificial layers SAL as a seed layer.

As another example, forming the silicon layer GL may include selectively growing silicon on the sacrificial layers SAL. For example, the silicon layer GL may be formed only on the outer walls of the sacrificial layers SAL exposed by the first recess RS1.

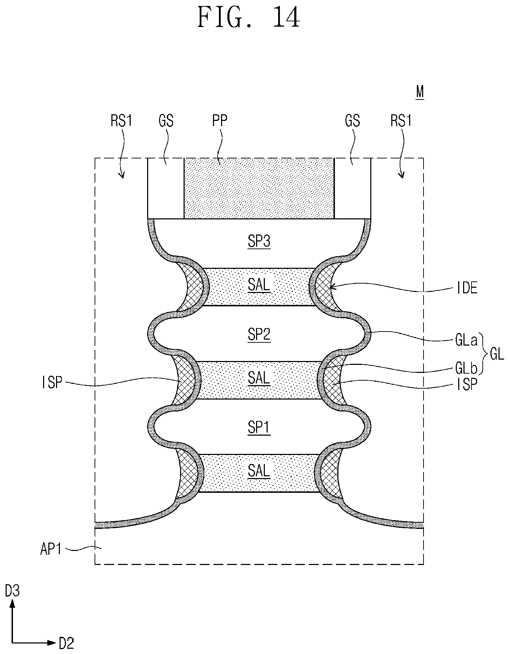

Referring to FIG. 14, an inner spacer ISP may be formed on the second portion GLb in the indented region IDE. The inner spacer ISP may partially fill the indent region IDE. Forming the inner spacer ISP may include forming an insulating layer that fills the indent region IDE through the first recess RS1 and wet etching the insulating layer exposed outside the indent region IDE. The insulating layer may include at least one of a silicon oxynitride layer and a silicon nitride layer.

The inner spacer ISP may include one side surface that is in contact with the silicon layer GL and the other side surface that is exposed by the first recess RS1. A curvature of one side surface may be smaller than a curvature of the other side surface. The inner spacer ISP may have a half-moon shape.

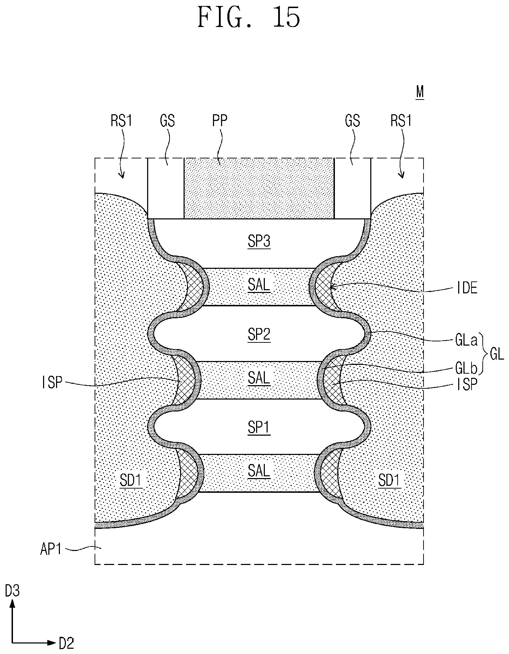

Referring to FIG. 15, a first source/drain pattern may be formed in the first recess RS1. In an embodiment, an SEG process may be performed using the first portion GLa exposed to the first recess RS1 and the substrate 100 as a seed layer to from an epitaxial layer filling the first recess RS1. The epitaxial layer may be grown using the first portion GLa exposed to the first recess RS 1 and the substrate 100 as a seed. As an example, the SEG process may include a chemical vapor deposition (CVD) process or a molecular beam epitaxy (MBE) process.

In an embodiment, the first source/drain pattern SD1 may include the same semiconductor element (e.g., Si) as the substrate 100. While the first source/drain pattern SD1 is being formed, impurities (e.g., phosphorus, arsenic, or antimony) may be implanted in-situ such that the first source/drain pattern SD1 has an n-type. As another example, after the first source/drain pattern SD1 is formed, impurities may be implanted into the first source/drain pattern SD1.

Second source/drain patterns SD2 may be respectively formed in the second recesses RS2. In an embodiment, an SEG process may be performed using the inner wall of the second recess RS2 as a seed layer, and thus the second source/drain pattern SD2 may be formed.

In one embodiment, the second source/drain pattern SD2 may include a semiconductor element (e.g., SiGe) having a lattice constant greater than a lattice constant of the semiconductor element of the substrate 100. While the second source/drain pattern SD2 is formed, impurities (e.g., boron, gallium, or indium) may be implanted in-situ such that the second source/drain pattern SD2 has a p-type. As another example, after the second source/drain pattern SD2 is formed, impurities may be implanted into the second source/drain pattern SD2.

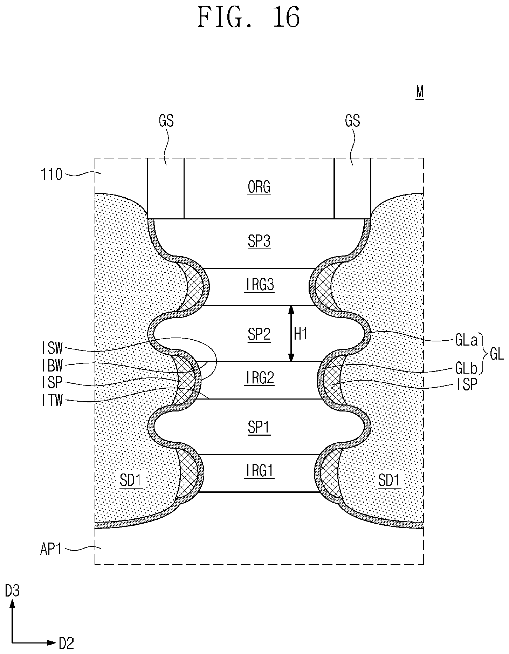

Referring to FIG. 16, a first interlayer insulating layer 110 may be formed covering the first source/drain pattern SD1 and the second source/drain pattern SD2, hard mask patterns MP, and gate spacers GS. As an example, the first interlayer insulating layer 110 may include a silicon oxide layer.

The first interlayer insulating layer 110 may be planarized until top surfaces of the sacrificial patterns PP are exposed. The planarization of the first interlayer insulating layer 110 may be performed using an etch-back or chemical mechanical polishing (CMP) process. During the planarization process, all of the hard mask patterns MP may be removed. As a result, a top surface of the first interlayer insulating layer 110 may be coplanar with top surfaces of the sacrificial patterns PP and top surfaces of the gate spacers GS.

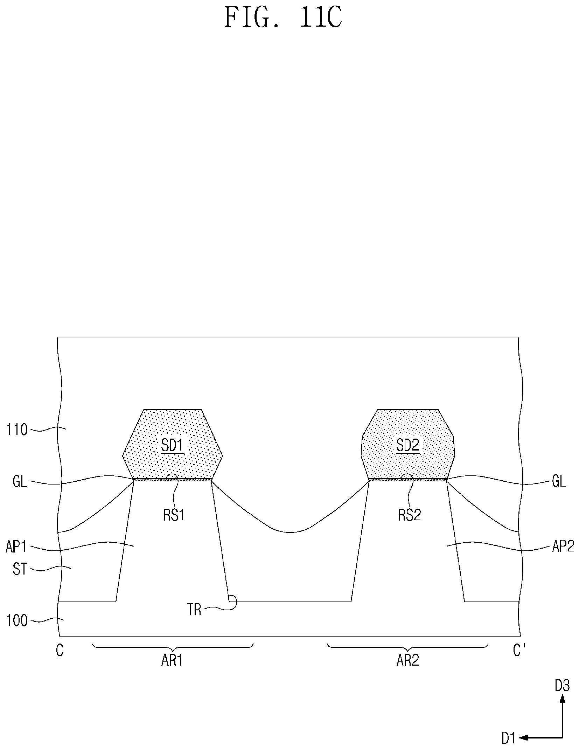

The exposed sacrificial patterns PP may be selectively removed. As the sacrificial patterns PP are removed, an outer region ORG exposing the first channel pattern CH1 and the second channel pattern CH2 may be formed (refer to FIG. 11C). The removing of the sacrificial patterns PP may include wet etching using an etchant that selectively etches polysilicon.

The sacrificial layers SAL exposed through the outer region ORG may be selectively removed to form inner regions IRG (refer to FIG. 11C). In an embodiment, an etching process of selectively etching the sacrificial layers SAL may be performed, and thus only the sacrificial layers SAL may be removed while the first to third semiconductor patterns SP1, SP2, and SP3 remain. The etching process may have a high etch rate with respect to silicon-germanium having a relatively high germanium concentration. For example, the etching process may have a high etching rate for silicon-germanium having a germanium concentration greater than 10 at%.

During the etching process, the sacrificial layers SAL on the first active region AR1 and the second active region AR2 may be removed. The etching process may be wet etching. The etching material used in the etching process may rapidly remove the sacrificial layer SAL having a relatively high germanium concentration.

In an embodiment, the first inner region IRG1 may be formed between the first or second active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Top and bottom surfaces of the first to third semiconductor patterns SP1, SP2, and SP3 may be exposed by the outer region ORG and the inner regions IRG. The second portion GLb of the silicon layer GL may be exposed by the inner regions IRG. For example, a top surface ITW of the first semiconductor pattern SP1, a bottom surface IBW of the second semiconductor pattern SP2, and one side surface ISW of the second portion GLb may be exposed.

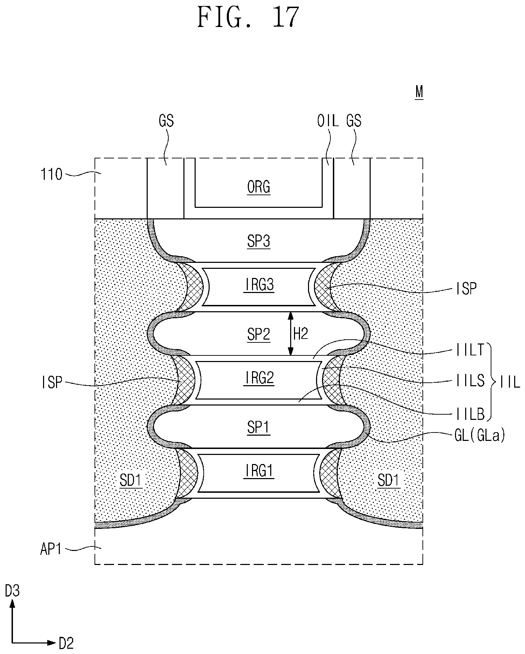

Referring to FIG. 17, an inner gate insulating layer III, may be formed on the exposed first to third semiconductor patterns SP1, SP2, and SP3. Forming the inner gate insulating layer III, may include forming an oxide layer by performing an oxidation process on the first to third inner regions IRG1, IRG2, and IRG3. For example, oxidation may be performed on the top and bottom surfaces of the first to third semiconductor patterns SP1, SP2, and SP3 and the second portion GLb exposed by the first to third inner regions IRG1, IRG2, and IRG3. Through the oxidation process, the inner gate insulating layer III, containing silicon oxide may be formed. As an example, the inner gate insulating layer III, may include SiO₂.

For example, a lower insulating layer IILB may be formed on the top surface of the first semiconductor pattern SP1 exposed by the second inner region IRG2. An upper insulating layer IILT may be formed on the bottom surface of the second semiconductor pattern SP2 exposed by the second inner region IRG2. The second portion GLb exposed by the second inner region IRG2 may be oxidized through the oxidation process to form the side insulating layer IILS. The oxidation process may be selectively performed only on the second portion GLb. Accordingly, only the first portion GLa may remain.

By the oxidation process, a thickness of the first to third semiconductor patterns SP1, SP2, and SP3 in the third direction D3 may be reduced. For example, a thickness H1 of the first to third semiconductor patterns SP1, SP2, and SP3 of FIG. 16 may be larger than a thickness H2 of the first to third semiconductor patterns SP1, SP2, and SP3 of FIG. 17.

Referring again to FIG. 6, a high dielectric layer HK and a gate electrode GE may be sequentially formed on the inner gate insulating layer III, and the outer gate insulating layer OIL, respectively. As described above, the high dielectric layer HK may include a high dielectric constant material that has a higher dielectric constant than the silicon oxide layer. For example, a high dielectric layer HK may be formed by performing an atomic layer deposition (ALD) deposition process.

According to the disclosure, the silicon layer GL may be formed before forming the inner spacer ISP. The silicon layer GL may be formed in the indent region IDE, thereby preventing the thickness of the semiconductor patterns SP1, SP2, and SP3 from being reduced due to the inner spacer ISP. Additionally, the inner gate insulating layer IIL may be formed by selectively performing the oxidation process only on the second portion GLb of the silicon layer GL. As a result, the inner gate insulating layer IIL may be formed between the gate electrode GE and the inner spacer ISP.

According to the disclosure, the silicon layer may be formed before the inner spacer is formed, and thus the thickness of the semiconductor patterns may be constant. The thickness of the silicon layer may be adjusted, thereby minimizing the resistance due to the decrease in the thickness of the semiconductor patterns. Additionally, the oxidation process may performed on the formed silicon layer to form the gate insulating layer. As a result, the electrical characteristics of the semiconductor device according to the disclosure may be improved.

While embodiments are described above, a person skilled in the art may understand that many modifications and variations are made without departing from the spirit and scope of the disclosure defined in the following claims. Accordingly, the example embodiments of the disclosure should be considered in all respects as illustrative and not restrictive, with the spirit and scope of the disclosure being indicated by the appended claims.

## Claims

1. A method of manufacturing a semiconductor device, the method comprising:
forming a stacked pattern comprising an active layer and a sacrificial layer stacked on a substrate, wherein the active layer comprises two active layers vertically adjacent to each other, and the sacrificial layer is interposed between the two active layers;
forming a recess by etching the stacked pattern;
forming an indent by etching a portion of the sacrificial layer exposed by the recess;
forming a silicon layer on an inner surface of the recess;
forming an inner spacer in the indent;
forming an inner region by removing the sacrificial layer; and
forming a gate insulating layer in the inner region,
wherein the forming the gate insulating layer comprises forming an oxide layer by performing an oxidation process on the silicon layer exposed by the inner region.

2. The method of claim 1, wherein the oxide layer is in direct contact with the inner spacer.

3. The method of claim 1, wherein the forming the silicon layer comprises performing an epitaxial growth process on the sacrificial layer and on semiconductor patterns exposed by the recess.

4. The method of claim 1, further comprising forming a semiconductor pattern from the active layer,
wherein the silicon layer comprises a first portion on the semiconductor pattern and a second portion on the sacrificial layer, and
wherein the oxidation process is selectively performed in the second portion through the inner region.

5. The method of claim 4, further comprising:
oxidizing a top surface and a bottom surface of the semiconductor pattern by the oxidation process, and
forming the gate insulating layer on the top surface and the bottom surface of the semiconductor pattern.

6. The method of claim 4, wherein a thickness of the semiconductor pattern in a vertical direction is reduced by the oxidation process.

7. The method of claim 1, further comprising forming the inner spacer and forming a source/drain pattern in the recess.

8. The method of claim 1, further comprising sequentially forming a high dielectric layer and a gate electrode in the inner region.

9. The method of claim 1, wherein the forming the silicon layer comprises selectively growing silicon on the sacrificial layer exposed by the recess.

10. A method of manufacturing a semiconductor device, the method comprising:
forming a stacked pattern comprising a semiconductor pattern and a sacrificial layer stacked on a substrate;
forming a recess by etching the stacked pattern;
forming an indent by etching a portion of the sacrificial layer exposed by the recess;
forming a silicon layer on an inner surface of the recess, the silicon layer comprising a first portion on the semiconductor pattern and a second portion on the sacrificial layer;
forming an inner spacer in the indent; and
forming a source/drain pattern in the recess,
wherein the semiconductor pattern comprises a body portion and a protrusion protruding from the body portion toward the source/drain pattern, and
wherein a highest level of the body portion and a highest level of the first portion covering the protrusion are equal to each other.

11. The method of claim 10, wherein the forming the first portion comprises performing an epitaxial growth process on the protrusion.

12. The method of claim 10, further comprising:
forming an inner region by removing the sacrificial layer and by exposing the second portion by the inner region, and
forming a gate insulating layer by performing an oxidation process on the exposed second portion.

13. The method of claim 12, wherein the forming the gate insulating layer comprises performing the oxidation process on a top surface and a bottom surface of the semiconductor pattern exposed by the inner region.

14. The method of claim 12, further comprising sequentially forming a high dielectric layer and a gate electrode in the inner region.

15. The method of claim 12, wherein a thickness of the semiconductor pattern in a vertical direction is reduced by the oxidation process.
